Europäisches Patentamt

European Patent Office

Office européen des brevets

(19)

(11) **EP 0 638 784 B1**

(12) **EUROPÄISCHE PATENTSCHRIFT**

(45) Veröffentlichungstag und Bekanntmachung des Hinweises auf die Patenterteilung:
**11.11.1998  Patentblatt 1998/46**

(51) Int Cl.6: **G01D 5/36**, H01L 27/144, H01L 27/15, H01L 31/173

(21) Anmeldenummer: **94110325.1**

(22) Anmeldetag: **02.07.1994**

(54) **Lichtelektrische Längen- oder Winkelmesseinrichtung**

Photo-electric length- or angle measuring device

Dispositif de mesure photo-électrique de longueurs et d'angles

(84) Benannte Vertragsstaaten:
**AT CH DE FR GB IT LI**

(30) Priorität: **15.07.1993  DE 4323712**

(43) Veröffentlichungstag der Anmeldung:
**15.02.1995  Patentblatt 1995/07**

(73) Patentinhaber: **Dr. Johannes Heidenhain GmbH D-83292 Traunreut (DE)**

(72) Erfinder:
• **Holzapfel, Wolfgang, Dr.rer.nat. Dipl.-Phys. D-83119 Obing (DE)**
• **Franz, Andreas, Dr. D-83308 Trostberg (DE)**

(56) Entgegenhaltungen:
EP-A- 0 157 177          EP-A- 0 541 828
DE-A- 1 905 392          DE-A- 3 616 144
DE-A- 4 041 584          DE-B- 1 282 988
US-A- 5 155 355

**Beschreibung**

Die Erfindung betrifft eine lichtelektrische Längen- oder Winkelmeßeinrichtung.

Derartige Meßeinrichtungen werden insbesondere bei Bearbeitungsmaschinen zur Messung der Relativlage eines Werkzeuges bezüglich eines zu bearbeitenden Werkstückes sowie bei Koordinatenmeßmaschinen zur Ermittlung von Lage und Abmessungen von Prüfobjekten eingesetzt.

Zur Vereinfachung der Herstellung ist aus der DE 40 06 789 A1 bereits bekannt, das Abtastgitter eines inkrementalen Meßsystemes direkt auf die lichtempfindliche Fläche eines Halbleitersubstrates aufzubringen. Das Abtastgitter ist direkt auf der ebenen Lichtaufnahmefläche aufgedruckt oder aufgeklebt. Eine ähnliche Einrichtung ist in der DE 19 05 392 B beschrieben.

Eine Weiterbildung dieser inkrementalen Meßeinrichtungen ist in der DE 32 09 043 A1 beschrieben. Das Abtastgitter ist ein Halbleitersubstrat, in dem aktive lichtempfindliche Streifen als Empfangselemente in Meßrichtung voneinander beabstandet ausgebildet sind. Das Abtastgitter in Form von lichtempfindlichen Streifen auszubilden ist weiterhin in der DE 19 62 099 B sowie der GB-PS 1311275 beschrieben.

Ebenso ist es bekannt, zur Beleuchtung eines inkrementalen Maßstabes eine flächig lichtemittierende Halbleiter-Lichtquelle einzusetzen, auf dessen lichtemittierender Oberfläche ein Gitter mit voneinander beabstandeten lichtabschirmenden Streifen aufgebracht ist. Eine derartige Meßeinrichtung ist in der US-PS 5,155,355 beschrieben, von der unsere Erfindung ausgeht.

Um bei lichtelektrischen inkrementalen Meßsystemen die Qualität der Abtastsignale zu erhöhen, sind ebenfalls verschiedene Maßnahmen bekannt. In der DE 12 82 988 B ist angegeben, daß durch geeignete Gitterausbildung des Maßstabes und der Abtasteinheit Oberwellen der Abtastsignale beseitigt werden können. Um möglichst viele ungeradzahlige Oberwellen zu unterdrücken, ist das Steg-Lücke-Verhältnis der beiden Gitter unterschiedlich gewählt.

Weitere Maßnahmen zur Filterung von Oberwellen sind in der EP 0 541 828 A1 und der EP 0 157 177 A2 angegeben. Diese Maßnahmen beziehen sich alle ausschließlich auf die Ausbildung der Abtastteilung, welche Fotodetektoren zugeordnet sind.

In der DE 40 41 584 A1 ist eine interferentielle Meßeinrichtung für zwei Meßrichtungen mit einem Kreuzgitter beschrieben. Es wird dabei nur auf die Möglichkeit hingewiesen, Oberwellen am Maßstab auszufiltern.

Aufgabe der Erfindung ist es, eine einfach aufgebaute Längen- oder Winkelmeßeinrichtung zu schaffen, bei der Oberwellen in den Abtastsignalen vermieden werden und dadurch eine hohe Meßgenauigkeit gewährleistet ist.

Die mit der Erfindung erzielten Vorteile bestehen insbesondere darin, daß durch einfache aus der Halbleiterfertigung bekannte Verfahren die Lichtquelle und die Abtastplatte strukturiert werden können, so daß nahezu oberwellenfreie Abtastsignale erzeugt werden.

Weiterhin ist ein kompakter Aufbau der Meßeinrichtung möglich.

Vorteilhafte Ausbildungen der Erfindung sind in den abhängigen Ansprüchen angegeben.

Ausführungsbeispiele der Erfindung werden anhand der Zeichnung näher erläutert.

Es zeigt

| | |
|---|---|
| Figur 1 | schematisch eine lichtelektrische Längenmeßeinrichtung gemäß der Erfindung; |
| Figur 2 | die Längenmeßeinrichtung nach Figur 1 im Schnitt; |
| Figur 3 | eine andere Ausgestaltung der Längenmeßeinrichtung im Schnitt; |
| Figur 4 | eine Draufsicht einer Abtastplatte gemäß der Erfindung; |
| Figur 5 | eine weitere Ausbildung der Erfindung und |
| Figur 6 bis 8 | Ausbildungen der Lichtquelle und der Abtastplatte auf einem Halbleitersubstrat. |

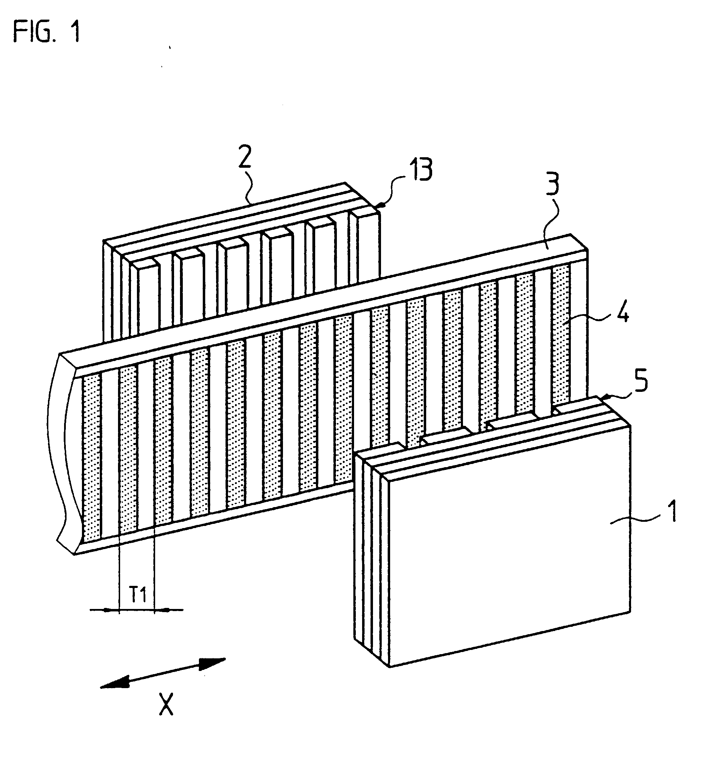

Figur 1 zeigt das Funktionsprinzip einer erfindungsgemäß ausgebildeten Längenmeßeinrichtung. Diese Längenmeßeinrichtung besteht aus einer Lichtquelle 1 und einer Abtastplatte 2 zur Erzeugung zumindest eines positionsabhängigen Abtastsignales. Ein Maßstab 3 ist zwischen der Lichtquelle 1 und der Abtastplatte 2 in Meßrichtung X relativ zur Lichtquelle 1 und Abtastplatte 2 verschiebbar. Eine derartige Meßeinrichtung wird auch als Dreigittermeßsystem bezeichnet. Der Maßstab 3 ist ein Glaskörper, an dessen Oberfläche eine inkrementale Teilung 4 in Form von abwechselnd lichtdurchlässigen und lichtundurchlässigen Strichen mit der Teilungsperiode T1 aufgebracht ist.

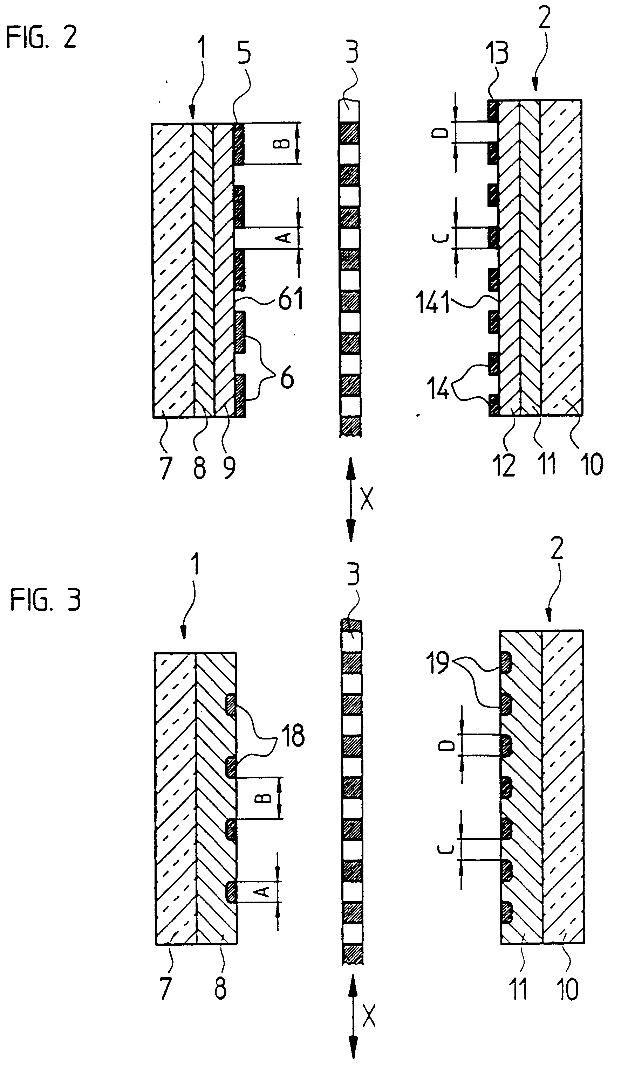

Die Lichtquelle 1 ist ein Halbleitersubstrat, auf dessen lichtemittierender Oberfläche ein Gitter 5 in Form von lichtabschirmenden Stegen 6 aufgebracht ist. Der Raum zwischen zwei Stegen 6 ist ein wirksam lichtemittierender Bereich 61. Der Schichtaufbau einer derartigen Lichtquelle 1 ist in Figur 2 im Schnitt ersichtlich. Auf einem Grundkörper 7 aus Glas, Metall oder Halbleitermaterial ist eine erste Halbleiterschicht 8 vom N-Typ aufgebracht. Zur Erzeugung eines PN-Überganges ist auf dieser ersten Halbleiterschicht 8 eine weitere Halbleiterschicht 9 vom P-Typ aufgebracht. Auf dieser großflächig lichtemittierenden Halbleiter-Lichtquelle 1 sind die senkrecht zur Meßrichtung X verlaufenden Stege 6 in bekannter Weise durch Lithographie-Verfahren gebildet. Die Breite B eines Steges 6 ist größer als die Lücke A zwischen den einzelnen Stegen 6.

Die Lücken A bilden die streifenförmig lichtemittierenden Bereiche 61. Das Verhältnis der Breite der Lücke 61 zur Breite B des Steges 6 ist 1:2 gewählt.

Die Abtastplatte 2 ist ebenfalls ein Halbleitersubstrat mit einem Grundkörper 10, einer ersten Halbleiterschicht 11 vom N-Typ und einer weiteren Halbleiterschicht 12 vom P-Typ. Durch den so gebildeten PN-Übergang ist eine großflächige lichtempfindliche Fläche gebildet, auf der direkt ein Abtastgitter 13 aufgebracht ist. Das Abtastgitter 13 besteht aus mehreren voneinander in Meßrichtung X beabstandeten lichtabschirmenden Stegen 14. Die Breite C eines Steges 14 entspricht der Breite D einer Lücke 141. Die Lücken sind die wirksamen lichtempfindlichen Bereiche 141 der Abtastplatte 2. Das Verhältnis der Breite D der Lücke 141 zur Breite C des Steges ist 1:1.

Bei den angegebenen Verhältnissen des Gitters 13 werden alle geradzahligen Oberwellen und des Gitters 5 alle Oberwellen der 3., 6., 9., ... Ordnung (d.h. ganzzahlig Vielfache von 3) unterdrückt.

Abweichend von den in der DE 12 82 988 offenbarten Maßnahmen muß der Maßstab 3 nicht besonders zur Unterdrückung von Oberwellen ausgebildet sein. Dies hat den Vorteil, daß die zur Filterung benötigten Gitter 5, 13 in Meßrichtung X nur relativ kurz ausgeführt werden müssen, was die Genauigkeit erhöht und die Fertigung vereinfacht. Gegenüber der DE 12 82 988 hat die Erfindung weiterhin den Vorteil, daß die geradzahligen Oberwellen durch die Ausbildung eines der Gitter 5 oder 13 unterdrückt werden. Es hat sich gezeigt, daß durch eine elektrische Gegentaktschaltung nach der DE 12 82 988 die geradzahligen Oberwellen in der Praxis nicht vollständig unterdrückt werden. Demgegenüber werden durch die Erfindung neben den Vielfachen der 3. Oberwelle auch die geradzahligen Oberwellen durch eines der Gitter 5, 13 ausgefiltert. Durch die Erfindung wird außerdem die Filterung dieser besonders störenden Oberwellen auf das Gitter 5 der Lichtquelle 1 und das Gitter 13 der Abtastplatte 2 verteilt, wodurch ein besonders hoher Modulationsgrad erreicht wird.

Das Verhältnis von Lücke A zu Stegbreite B bzw. D zu C kann auch anders gewählt werden. Bei der Dimensionierung der Gitter 5, 13 ist erfindungsgemäß darauf zu achten, daß ein Gitter 5 oder 13 zumindest eine weitere Oberwelle des Abtastsignales unterdrückt, als das andere Gitter 13 oder 5. Dabei sind folgende Verhältnisse möglich:

$$B = m1 * \frac{P}{n}$$

und

$$A = m2 * \frac{P}{n}$$

mit

P = Teilungsperiode des entsprechenden Gitters 5 oder 13

n = Ordnungszahl einer zu eliminierenden Oberwelle der Abtastsignale

m1, m2 = ganze Zahlen mit m1+m2=n

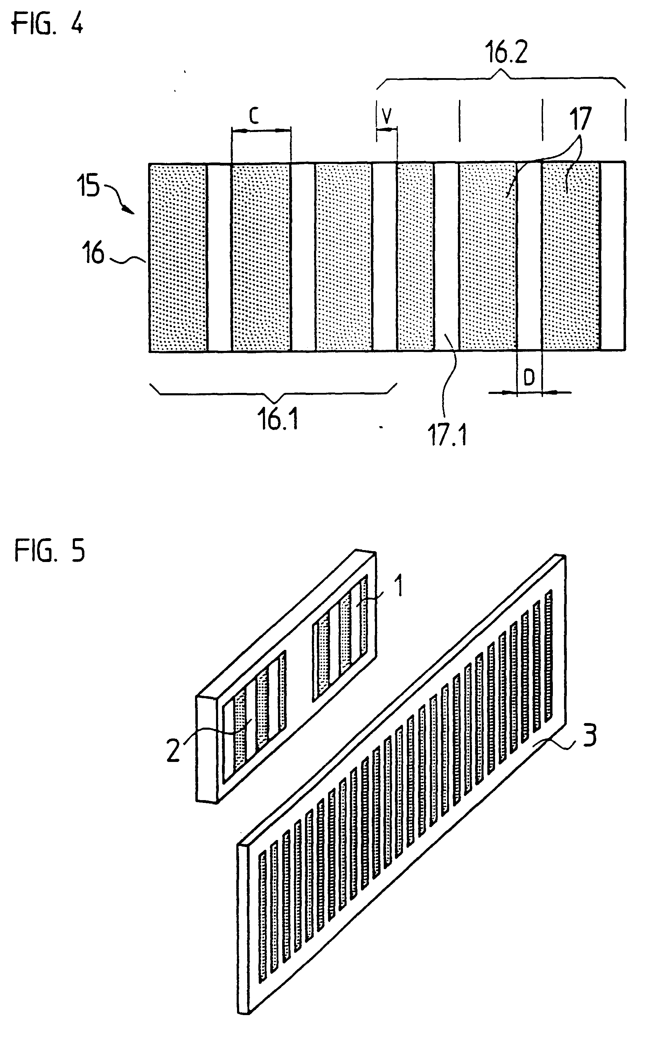

Um bei einem der Gitter 5, 13 bestimmte Oberwellen zu unterdrücken, sind auch andere Maßnahmen möglich. Ein weiteres Beispiel ist in Figur 4 dargestellt. In Figur 4 ist in Draufsicht eine Abtastplatte 15 mit dem Abtastgitter 16 gezeigt. Das Abtastgitter 16 besteht aus zwei Abschnitten 16.1 und 16.2, zwischen denen ein Phasenversatz V von 90° besteht. Beide Gitterabschnitte 16.1 und 16.2 sind auf einem gemeinsamen Halbleitersubstrat aufgebracht, so daß eine Addition der durch beide Abschnitte 16.1 und 16.2 fallenden Lichtströme erfolgt. Das bedeutet, daß die störenden Oberwellen geradzahliger Ordnungen in Gegentakt geschaltet sind und sich dadurch auslöschen. Es können auch andere Oberwellen unterdrückt werden, wenn ein anderer Phasenversatz V gewählt wird. Das Verhältnis der Breite D der Lücke 171 zur Breite C der lichtabschirmenden Stege 17 ist im Beispiel 1:2 gewählt, wodurch zusätzlich mit dem Abtastgitter 16 ungeradzahlige Oberwellen der Ordnungen 3, 6, 9... unterdrückt werden. Bei Verwendung dieser Abtastplatte 15 in der Längenmeßeinrichtung nach Figur 1 ist das Gitter 5 der Lichtquelle 1 vorteilhaft so ausgebildet, daß zusätzlich die Vielfachen der 5. Oberwelle unterdrückt werden. Das Verhältnis der Breite A der Lücke 141 zur Breite B der Stege 6 kann hierzu beispielsweise 2:3 gewählt werden.

Das Abtastgitter 16 und/oder das Gitter 5 der Lichtquelle 1 kann auch gemäß der EP 0 106 951 B1, der EP 0 157 177 B1 oder der EP 0 541 828 A1 ausgebildet sein.

Die Lichtquelle 1 und/oder die Abtastplatte 2 kann auch wie in Figur 3 dargestellt ist, ausgestaltet sein. Die Lichtquelle 1 besteht aus einem Grundkörper 7 mit einer Halbleiterschicht 8 vom N-Typ. Die lichtemittierenden Oberflächenbereiche 18 in Form von in Meßrichtung X beabstandeten Einzelelementen sind direkt in dieser Halbleiterschicht 8 ausgebildet, wodurch sich die Verwendung von lichtabschirmenden Stegen erübrigt. In der Halbleiterschicht 8 sind diese streifenförmigen Bereiche 18 als PN-Übergänge durch Ausbildung von P-Bereichen 18 realisiert und bilden somit selbst das Gitter.

Die Abtastplatte 2 besteht ebenfalls aus einem einzigen Halbleitersubstrat, bei dem auf einem Grundkörper eine Halbleiterschicht vom N-Typ aufgebracht ist. Durch Dotierung sind in dieser Halbleiterschicht in Meßrichtung X voneinander beabstandete P-Bereiche 19 zur Bildung von PN-Übergängen eingebracht. Jeder PN-Übergang ist ein lichtempfindlicher Bereich 19, wodurch sich auch hier die Verwendung von lichtabschirmenden Stegen erübrigt. Auch hier wird das Gitter von den PN-Übergängen und den dazwischenliegenden Bereichen selbst gebildet.

Die Dimensionierung der lichtemittierenden Bereiche 18 und der lichtempfindlichen Bereiche 19 erfolgt wie im Beispiel nach Figur 2. Der Abstand der lichtemittierenden Bereiche 18 entspricht dabei der Stegbreite B, die Breite eines lichtemittierenden Bereiches 18 der Lücke A.

Der Abstand der lichtempfindlichen Bereiche 19 entspricht der Stegbreite C und die Breite eines lichtempfindlichen Bereiches der Lücke D.

Wie bereits erläutert wurde, ist die Erfindung besonders vorteilhaft bei einem Dreigittermeßsystem einsetzbar. Die Erfindung ist aber nicht darauf beschränkt, sie ist auch bei einem Zweigittermeßsystem einsetzbar, bei dem das eine Gitter die Lichtquelle 1 und das relativ dazu in Meßrichtung X verschiebbare Gitter die Abtastplatte 2 ist, d.h., daß eines dieser beiden Gitter als Maßstab wirkt.

Die Erfindung ist weiterhin bei Längen- und Winkelmeßeinrichtungen einsetzbar.

Zur Gewinnung phasenverschobener Abtastsignale können mehrere gegeneinander phasenverschobene Gitter der Lichtquelle und/oder der Abtastplatte verwendet werden.

Bei allen Ausführungsformen kann für die Lichtquelle und die Abtastplatte ein gemeinsames Halbleitersubstrat verwendet werden, wobei die Gitter der Lichtquelle und der Abtastplatte dann in einer gemeinsamen Ebene liegen. Beispiele hierzu sind in den Figuren 5 bis 8 gezeigt.

Das Dreigittermeßsystem nach Figur 5 besteht aus einem Halbleitersubstrat, auf dem die streifenförmig emittierende Lichtquelle 1 sowie die streifenförmig lichtempfindliche Abtastplatte 2 integriert sind.

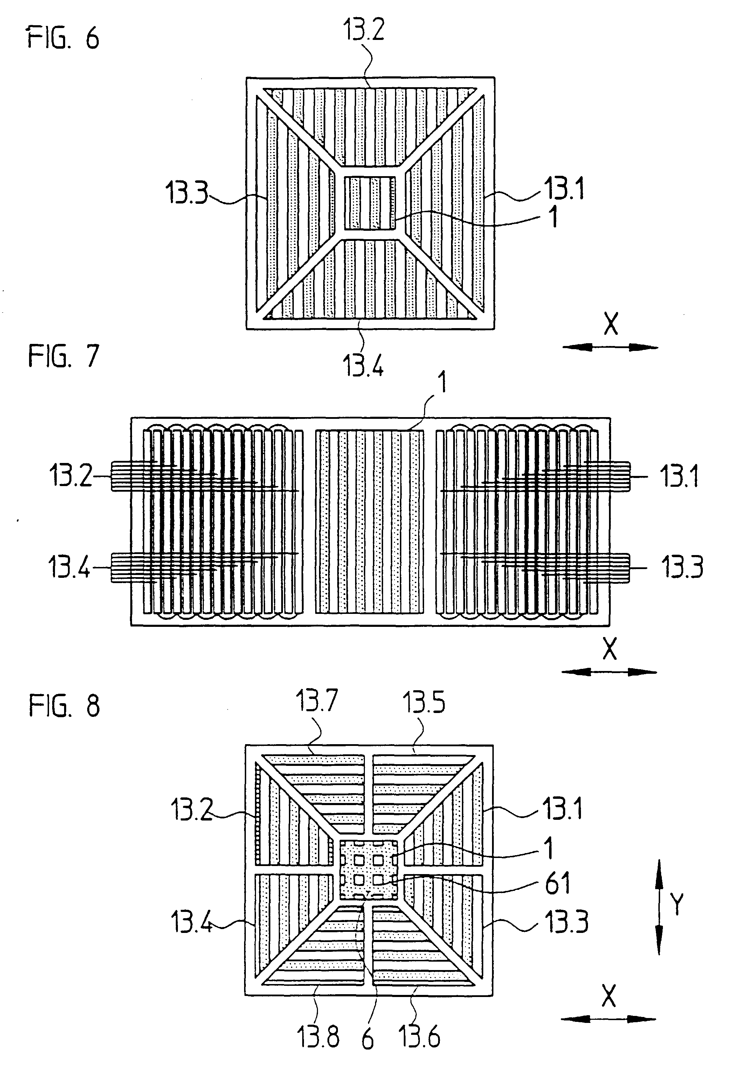

In Figur 6 ist die Lichtquelle 1 zentrisch zu den Abtastgittern 13.1 bis 13.4 zur Erzeugung von vier um jeweils 90° gegeneinander phasenverschobenen Abtastsignalen angeordnet.

In Figur 7 sind die Abtastgitter 13.1 bis 13.4 in Meßrichtung X gesehen an beiden Seiten der Lichtquelle 1 angeordnet. Wobei die Abtastgitter 13.1, 13.3 sowie 13.2, 13.4 auf jeweils einer Seite um 180° gegeneinander phasenversetzt sind. Besonders vorteilhaft ist es, wenn die Abtastgitter 13.1 und 13.3 sowie 13.2 und 13.4 ineinander verschachtelt sind.

In Figur 8 ist eine strukturierte Lichtquelle 1 zur Beleuchtung eines Kreuzgittermaßstabes gezeigt. Die lichtemittierenden Bereiche 61 sind zwischen den sich kreuzenden lichtabschirmenden Stegen 6 gebildet. Die Abtastgitter 13.1 und 13.3 zur Erzeugung des 0°- und 90°-Abtastsignales für die X-Richtung sind auf einer Seite der Lichtquelle 1 und die Abtastgitter 13.2 und 13.4 zur Erzeugung des 270°- und 180°-Abtastsignales für die X-Richtung auf der anderen Seite angeordnet.

Die Abtastgitter 13.5 bis 13.8 für die Y-Richtung sind oberhalb und unterhalb der Lichtquelle 1 angeordnet. Das Funktionsprinzip eines Kreuzgittermeßsystemes an sich ist in der DE 40 41 584 Al beschrieben, womit sich weitere Erläuterungen hierzu erübrigen.

## Patentansprüche

1. Lichtelektrische Längen- oder Winkelmeßeinrichtung mit einem im Strahlengang zwischen einer Lichtquelle und einer Abtastplatte relativ zur Lichtquelle und der Abtastplatte verschiebbaren Maßstab, wobei die Lichtquelle eine Halbleiter-Lichtquelle mit mehreren in Meßrichtung beabstandet emittierenden Bereichen ist und die Abtastplatte mehrere in Meßrichtung beabstandete streifenförmig lichtempfindliche Bereiche aufweist, wobei das Verhältnis der Breite (A) zum Abstand (B) der lichtemittierenden Bereiche (61, 18) der Lichtquelle (1) vom Verhältnis der Breite (D) zum Abstand (C) der lichtempfindlichen Bereiche (141, 19) der Abtastplatte (2) abweicht und die Verhältnisse derart gewählt sind, daß mittels der Abtastplatte (2) geradzahlige Oberwellen und mittels der Lichtquelle (1) die 3. Oberwelle oder mittels der Lichtquelle (1) geradzahlige Oberwellen und mittels der Abtastplatte (2) die 3. Oberwelle ausgefiltert werden.

2. Lichtelektrische Längen- oder Winkelmeßeinrichtung nach Anspruch 1, dadurch gekennzeichnet, daß die Abtastplatte (2, 15) ein Halbleitersubstrat aufweist, auf dessen lichtempfindlicher Fläche ein Abtastgitter (13, 16) aus voneinander in Meßrichtung X beabstandeten lichtabschirmenden Stegen (14, 17) aufgebracht ist, und die dazwischenliegenden Bereiche die streifenförmig lichtempfindlichen Bereiche (141, 171) sind.

3. Lichtelektrische Längen- oder Winkelmeßeinrichtung nach Anspruch 1, dadurch gekennzeichnet, daß die Lichtquelle (1) ein Halbleitersubstrat aufweist, auf dessen lichtemittierender Fläche ein Gitter (5) mit voneinander in Meßrichtung X beabstandeten lichtabschirmenden Stegen (6) aufgebracht ist, wobei die dazwischenliegenden Bereiche die streifenförmig lichtemittierenden Bereiche (61) sind.

4. Lichtelektrische Längen- oder Winkelmeßeinrichtung nach Anspruch 1, dadurch gekennzeichnet, daß die Abtastplatte (2) ein Halbleitersubstrat ist, in dem die lichtempfindlichen Bereiche als voneinander beabstandete streifenförmige PN-Ubergänge (19) eingebracht sind.

5. Lichtelektrische Längen- oder Winkelmeßeinrichtung nach Anspruch 1, dadurch gekennzeichnet, daß die Lichtquelle (1) ein Halbleitersubstrat ist, in dem die lichtemittierenden Bereiche als voneinander beabstandete streifenförmige PN-Ubergänge (18) eingebracht sind.

6. Lichtelektrische Längen- oder Winkelmeßeinrichtung nach einem der vorhergehenden Ansprüche, dadurch gekennzeichnet, daß die Lichtquelle (1) und die Abtastplatte (2) auf einem einzigen Substrat derart ausgebildet sind, daß die lichtemittierenden Bereiche (61, 18) und die lichtempfindlichen Bereiche (141, 19) in einer gemeinsamen Ebene liegen.

7. Lichtelektrische Längen- oder Winkelmeßeinrichtung nach einem der vorhergehenden Ansprüche, dadurch gekennzeichnet, daß die Lichtquelle (1) zentrisch zu mehreren Abtastbereichen (13.1 bis 13.4) der Abtastplatte angeordnet ist.

8. Lichtelektrische Längen- oder Winkelmeßeinrichtung nach einem der vorhergehenden Ansprüche, dadurch gekennzeichnet, daß der Maßstab ein Kreuzgitter aufweist, und daß die Lichtquelle (1) in mehreren Meßrichtungen (X, Y) voneinander beabstandet angeordnete lichtemittierende Bereiche (61) sowie die Abtastplatte senkrecht zueinander verlaufende lichtempfindliche Bereiche aufweist.

**Claims**

1. A photoelectric length or angle measuring device with a measuring scale movable relative to a light source and a sensing plate in the beam path between the light source and the sensing plate, wherein the light source is a semiconductor light source with a plurality of emitting regions spaced in the measuring direction and the sensing plate has a plurality of strip form light sensitive regions spaced in the measuring direction, wherein the ratio of the width (A) to the spacing (B) of the light emitting regions (61, 18) of the light source (1) differs from the ratio of the width (D) to the spacing (C) of the light sensitive regions (141, 19) of the sensing plate (2) and the ratios are so selected that even numbered harmonics and the 3rd harmonic are filtered out by means of the sensing plate (2) and the light source (1) respectively or even numbered harmonics and the 3rd harmonic are filtered out by means of the light source (1) and the sensing plate (2) respectively.

2. A photoelectric length or angle measuring device according to claim 1, characterized in that the sensing plate (2, 15) has a semiconductor substrate, on the light sensitive surface of which a sensing grating (13, 16) is formed by light shielding bars (14, 17) spaced from one another in the measuring direction X and the intervening regions are the strip form light sensitive regions (141, 171).

3. A photoelectric length or angle measuring device according to claim 1, characterized in that the light source (1) has a semiconductor substrate, on the light emitting surface of which is applied a grating (5) with light shielding bars (6) spaced from one another in the measuring direction X, wherein the intervening regions are the strip form light emitting regions (61).

4. A photoelectric length or angle measuring device according to claim 1, characterized in that the sensing plate (2) is a semiconductor substrate, in which the light sensitive regions are formed as strip form PN junctions (19) spaced from one another.

5. A photoelectric length or angle measuring device according to claim 1, characterized in that the light source (1) is a semiconductor substrate, in which the light emitting regions are formed as strip form PN junctions (18) spaced from one another.

6. A photoelectric length or angle measuring device according to any of the preceding claims, characterized in that the light source (1) and the sensing plate (2) are so formed on a single substrate that the light emitting regions (61, 18) and the light sensitive regions (141, 19) lie in a common plane.

7. A photoelectric length or angle measuring device according to any of the preceding claims, characterized in that the light source (1) is disposed centrally with respect to a plurality of sensing regions (13.1 to 13.4) of the sensing plate.

8. A photoelectric length or angle measuring device according to any of the preceding claims, characterized in that the measuring scale has a crossed grating and in that the light source (1) comprises light emitting regions (61) spaced from one another in a plurality of directions (X, Y) and the sensing plate comprises light sensitive regions perpendicular to one another.

**Revendications**

1. Dispositif photoélectrique de mesure de longueurs ou d'angles avec une règle graduée qui peut se déplacer dans la marche des rayons entre une source de lumière et une plaque de palpage par rapport à la source de lumière et à la plaque de palpage, la source de lumière étant une source de lumière à semi-conducteurs avec plusieurs zones émettrices espacées dans la direction de mesure et la plaque de palpage présentant plusieurs zones sensibles à la lumière en forme de bandes espacées dans la direction de mesure, le rapport de la largeur (A) à la distance (B) entre zones émettrices (61, 18) de la source de lumière (1) étant différent du rapport de la largeur (D) et à la distance (C) entre zones sensibles à la lumière (141, 19) de la plaque de palpage (2) et les rapports étant choisis de manière à éliminer à l'aide de la plaque de palpage (2) les harmoniques paires et à l'aide de la source de lumière (1) la troisième harmonique ou à l'aide de la source de lumière (1) les harmoniques paires et à l'aide de la plaque de palpage (2) la troisième harmonique.

2. Dispositif photoélectrique de mesure de longueurs ou d'angles selon la revendication 1, caractérisé par le fait que la plaque de palpage (2, 15) présente un substrat semi-conducteur sur la surface sensible à la lumière duquel est appliqué un réseau de palpage (13, 16) formé de barrettes (14, 17) formant écran qui sont espacées les unes des autres dans la direction de mesure X et que les zones situées entre deux sont les zones (141, 171) en forme de bandes sensibles à la lumière.

3. Dispositif photoélectrique de mesure de longueurs ou d'angles selon la revendication 1, caractérisé par le fait que la source de lumière (1) présente un substrat semi-conducteur sur la surface émettrice de lumière duquel est appliqué un réseau (5) de barrettes (6) formant écran qui sont espacées les unes des autres dans la direction de mesure X et que les zones situées entre deux sont les zones (61) en forme de bandes émettrices de lumière.

4. Dispositif photoélectrique de mesure de longueurs ou d'angles selon la revendication 1, caractérisé par le fait que la plaque de palpage (2) est un substrat semi-conducteur dans lequel les zones sensibles à la lumière sont aménagées en tant que transitions PN (19) en forme de bandes espacées les unes des autres.

5. Dispositif photoélectrique de mesure de longueurs ou d'angles selon la revendication 1, caractérisé par le fait que la source de lumière (1) est un substrat semi-conducteur dans lequel les zones émettrices de lumière sont aménagées en tant que transitions PN (18) en forme de bandes espacées les unes des autres.

6. Dispositif photoélectrique de mesure de longueurs ou d'angles selon une des revendications précédentes, caractérisé par le fait que la source de lumière (1) et la plaque de palpage (2) sont formées sur un substrat unique de telle sorte que les zones émettrices de lumière (61, 18) et les zones sensibles à la lumière (141, 19) sont situées dans un plan commun.

7. Dispositif photoélectrique de mesure de longueurs ou d'angles selon une des revendications précédentes, caractérisé par le fait que la source de lumière (1) est centrée par rapport à plusieurs zones de palpage (13.1 à 13.4) de la plaque de palpage.

8. Dispositif photoélectrique de mesure de longueurs ou d'angles selon une des revendications précédentes, caractérisé par le fait que la règle graduée présente un réseau croisé et que la source de lumière (1) présente des zones émettrices de lumière (61) mutuellement espaces dans plusieurs direction de mesure (X, Y) et la plaque de palpage des zones sensibles à la lumière mutuellement perpendiculaires.

FIG. 1

FIG. 2

FIG. 3

FIG. 4

FIG. 5

FIG. 6

13.2

13.3

13.1

1

X

FIG. 7

1

13.2

13.1

13.4

13.3

X

FIG. 8

13.7

13.5

13.2

13.1

1

61

13.4

13.3

Y

13.8

6

13.6

X